# EUROPÄISCHE PATENTSCHRIFT

(11) **EP 2 510 620 B1**
(45) Veröffentlichungstag und Bekanntmachung des Hinweises auf die Patenterteilung: **08.04.2020**
(21) Anmeldenummer: 10800715.4
(22) Anmeldetag: 13.12.2010
(51) Int. Cl.: H03K 17/96

(54) **EINRICHTUNG UND VERFAHREN ZUR DETEKTION EINES UMGREIFENS EINES HANDGERÄTS DURCH EINE HAND**
DEVICE AND METHOD FOR DETECTING A HAND-HELD DEVICE BEING CLASPED BY A HAND
DISPOSITIF ET PROCÉDÉ DE DÉTECTION DE LA SAISIE D'UN APPAREIL MANUEL PAR UNE MAIN

(30) Priorität: 11.12.2009 DE 102009057935
(43) Veröffentlichungstag der Anmeldung: 17.10.2012
(73) Patentinhaber: Neodrón Limited, Dublin 18, D18A094 (IE)
(72) Erfinder: KALTNER, Claus, 85221 Dachau (DE); UNTERREITMAYER, Reinhard, 82131 Gauting (DE)
(74) Vertreter: Peterreins Schley
(86) Internationale Anmeldenummer: PCT/EP2010/069514
(87) Internationale Veröffentlichungsnummer: WO 2011/070176

(56) Entgegenhaltungen:
- EP-A1- 1 440 771
- EP-A1- 2 294 695
- EP-A1- 2 436 118
- WO-A2-2009/130165
- DE-A1-102007 042 221
- DE-A1-102008 020 819
- US-A1- 2002 154 039

## Beschreibung

### Gebiet der Erfindung

Die Erfindung betrifft eine Einrichtung für ein elektrisches Handgerät zur Detektion eines Umgreifens des Handgeräts durch eine Hand, so dass bei einem Umgreifen des Handgerätes durch die Hand das Handgerät beispielsweise von einem Schlafmodus in einen Aktivmodus überführbar ist. Die Erfindung betrifft des Weiteren ein elektrisches Handgerät mit einer erfindungsgemäßen Detektionseinrichtung sowie ein Verfahren zur Detektion eines Umgreifens eines elektrischen Handgerätes durch eine Hand.

### Stand der Technik

In der Technik von elektrischen Geräten und insbesondere von elektrischen Handgeräten besteht seit langem der Wunsch nach einer verbesserten Energieeffizienz. Insbesondere bei tragbaren Handgeräten, wie etwa Fernbedienungen oder Mobiltelefonen, welche zur Energieversorgung Batterien oder Akkumulatoren vorsehen, ist ein solcher Wunsch verstärkt vorhanden, da Batterien oder Akkumulatoren sich schnell erschöpfen. Eine verbesserte Energieeffizienz würde die Stromaufnahme senken, was zu einer höheren Lebensdauer der Batterien oder Akkumulatoren führt. Zusätzlich würde eine verbesserte Energieeffizienz einen vorteilhaften ökologischen Effekt mit sich bringen, da weniger Batterien bzw. Akkumulatoren der Entsorgung zugeführt werden müssen.

Aus dem Stand der Technik ist bekannt, elektrische Handgeräte bei Nichtgebrauch in einen sogenannten Schlafmodus zu versetzen. Im Schlafmodus werden alle Funktionen des Handgerätes deaktiviert, welche nur während einer Bedienphase des Handgerätes benötigt werden. Damit kann die Leistungsaufnahme des elektrischen Handgerätes deutlich reduziert werden. Bei Gebrauch des Handgerätes wird dieses in einen Aktivmodus versetzt, in weichem die volle Funktionalität bzw. Funktionsfähigkeit des Gerätes zur Verfügung sicht.

Um ein Handgerät einerseits in den Schlafmodus zu versetzen und andererseits vom Schlafmodus in den Aktivmodus zu bringen, ist es bekannt, am Handgerät Schalter bzw. Tasten vorzusehen, mit welchen der jeweilige Modus manuell aktiviert werden kann. Dies hat den Nachteil, dass Handgeräte auch bei Nichtgebrauch, wie etwa bei einer Computermaus oft im Aktivmodus verbleiben, da eine manuelle Aktivierung bzw. Deaktivierung des Aktivmodus relativ umständlich erscheint oder einfach vergessen wird. Die gewünschte Verbesserung der Energieeffizienz wird dadurch zu einem großen Teil nicht erreicht.

WO 2009/130165 A2 diskutiert ein elektrisches Handgerät mit mindestens einer Sendeelektrode, mindestens einer Empfangselektrode und mindestens einer Kompensationselektrode.

### Aufgabe der Erfindung

Aufgabe der vorliegenden Erfindung ist es daher, Lösungen bereitzustellen, mit welchen die Energieeffizienz elektrischer Handgeräte zuverlässig verbessert werden kann und der Bedienkomfort der elektrischen Handgeräte gleichzeitig verbessert werden kann.

### Erfindungsgemäße Lösung

Diese Aufgabe wird erfindungsgemäß durch ein elektrisches Handgerät nach Anspruch 1 sowie durch ein Verfahren zur Detektion eines Umgreifens eines elektrischen Handgerätes nach Anspruch 10 gelöst. Vorteilhafte Ausgestaltungen der Erfindung sind in den jeweiligen abhängigen Ansprüchen angegeben.

Der Rahmen der Erfindung wird somit durch den Schutzumfang der Ansprüche definiert. Der Gegenstand jeglichen Bezugs auf "Ausführungsformen", "Beispiele" oder "Aspekte" der Erfindung in der Beschreibung, welcher nicht unter den Schutzumfang der Ansprüche fällt, sollte daher lediglich als Illustration oder Beispiel zum besseren Verständnis der Erfindung interpretiert werden.

Bereitgestellt wird demnach ein elektrisches Handgerät, aufweisend eine Einrichtung zur Detektion eines Umgreifens des Handgerätes, durch eine Hand, wobei das Handgerät ein Gehäuse mit einer Unterseite und gegenüberliegenden Seitenwänden hat, aufweisend
- mindestens eine Sendeelektrode, von welcher ein elektrisches Wechselfeld emittierbar ist, und
- mindestens eine Empfangselektrode, in welche das elektrische Wechselfeld zumindest teilweise einkoppelbar ist,
wobei die mindestens eine Sendeelektrode und die mindestens eine Empfangselektrode an dem Handgerät so angeordnet sind, dass sie beim Umgreifen des Handgerätes mit der Hand jeweils zumindest teilweise von der Hand überdeckt werden, wobei beim Umgreifen des Handgerätes mit der Hand ein erster Anteil des von der Sendeelektrode emittierten elektrischen Wechselfeldes über die Hand in die Empfangselektrode eingekoppelt wird, und wobei der erste Anteil des elektrischen Wechselfeldes ein für ein Umfassen des Handgerätes durch die Hand repräsentatives Merkmal ist.

Ein Wesentlicher Vorteil besteht darin, dass die erfindungsgemäße Einrichtung selbst nur einen sehr wenig Energie benötigt, um zuverlässig ein Umgreifen des Handgerätes durch eine Hand zu detektieren. Zudem wird die Bedienung bzw. die Benutzung des Handgerätes deutlich vereinfacht, weil kein Tastendruck mehr notwendig ist, um das Handgerät einerseits von einem Schlafmodus in einen Bedien- bzw. Aktivmodus zu überführen und andererseits von einem Bedien- bzw. Aktivmodus in einen Schlafmodus zu überführen. Dabei hat es sich als besonders vorteilhaft herausgestellt, dass auf die im Stand der Technik für das Umschalten der Betriebsmodi vorgesehenen Tasten verzichtet werden kann, was zusätzliche gestalterische Freiheiten für das Design des Handgerätes mit sich bringt.

Die Einrichtung weist erfindungsgemäß mindestens eine mit dem Massepotential des elektrischen Handgerätes gekoppelte elektrisch leitfähige Struktur auf, wobei die elektrisch leitfähige Struktur so relativ zur Sendeelektrode und zur Empfangselektrode angeordnet ist, um bei Nicht-Umgreifen des Handgerätes ein Einkoppeln des von der Sendeelektrode emittierten elektrischen Wechselfeldes in die Empfangselektrode im Wesentlichen zu verhindern.

Die elektrisch leitfähige Struktur kann so relativ zur Sendeelektrode und zur Empfangselektrode angeordnet sein, dass
- ein zweiter Anteil des elektrischen Wechselfeldes in die elektrisch leitfähige Struktur einkoppelbar ist und
- ein dritter Anteil des elektrischen Wechselfeldes, welcher betragsmäßig kleiner ist als der zweite Anteil, in die Empfangselektrode einkoppelbar ist,
um bei Nicht-Umgreifen des Handgerätes ein Einkoppeln des von der Sendeelektrode emittierten elektrischen Wechselfeldes in die Empfangselektrode im Wesentlichen zu verhindern, wobei beim Umgreifen des Handgerätes der dritte Anteil des elektrischen Wechselfeldes betragsmäßig kleiner ist als der erste Anteil des elektrischen Wechselfeldes.

Damit kann sehr genau unterschieden werden, ob das an der Empfangselektrode eingekoppelte elektrische Wechselfeld durch ein Umgreifen des Handgerätes mit einer Hand bewirkt wird, d.h. über die Hand in die Empfangselektrode eingekoppelt wird, oder durch ein z.B. elektrisch leitfähige Ablagefläche auf welcher das Handgerät abgelegt worden ist. Fehlinterpretation bzw. Fehlfunktionen können so effizient vermieden werden, weil das an der Empfangelektrode eingekoppelte elektrische Wechselfeld im abgelegten Zustand sehr viel kleiner ist als im Umgriffenen Zustand.

Der erste Anteil des elektrischen Wechselfeldes kann in der Empfangselektrode einen ersten elektrischen Strom erzeugen und der dritte Anteil des elektrischen Wechselfeldes kann in der Empfangselektrode einen zweiten elektrischen Strom erzeugen, wobei in das repräsentative Merkmal zusätzlich der dritte Anteil des elektrischen Wechselfeldes einfliest, indem das repräsentative Merkmal durch den aus dem ersten elektrischen Strom und dem zweiten elektrischen Strom resultierenden Gesamtstrom gebildet wird.

Ein Gesamtstrom oberhalb einer vorbestimmten Schwelle kann indikativ für ein Umfassen des Handgerätes ist. Diese Schwelle kann abhängig vom Gerät eingestellt werden.

Ferner kann der Gesamtstrom, welcher betragsmäßig größer ist als ein vorbestimmter Schwellenwert, indikativ für ein Umfassen des Handgerätes ist.

Das Handgerät kann so ausgestaltet sein, dass die Sendeelektrode und die Empfangselektrode auf der Oberfläche oder nahe unterhalb der Oberfläche des Gehäuses anordenbar sind.

Die Sendeelektrode ist an einer ersten Seitenwandung eines Gehäuses des Handgerätes angeordnet und die Empfangselektrode ist an einer zweiten Seitenwandung des Gehäuses des Handgerätes angeordnet. Die erste Seitenwandung ist gegenüber der zweiten Seitenwandung angeordnet. Damit wird besonders einfach gewährleistet, dass bei einem Umgreifen des Handgerätes durch eine Hand die Sendeelektrode und die Empfangselektrode zumindest teilweise von der Hand überdeckt werden und im abgelegten Zustand des Handgerätes ein Einkoppeln des elektrischen Wechselfeldes in die Empfangselektrode über die Ablagefläche größtenteils vermieden wird.

Als besonders vorteilhaft hat sich herausgestellt, die Flächen der Sendeelektrode und der Empfangselektrode jeweils so zu wählen, dass sie im Wesentlichen der Berührfläche der Hand an dem Gehäuse entsprechen.

Die Empfangselektrode kann mit einem kapazitiven Sensor koppelbar sein, welcher einen Signalgenerator umfasst, wobei das Ausgangssignal des kapazitiven Sensors von der kapazitiven Belastung des Sensors an der Empfangselektrode abhängig ist, wobei die Sendeelektrode über einen Phasenschieber mit dem Signalgenerator gekoppelt ist, um die Sendeelektrode mit einem zum Signal des Signalgenerators phasenverschobenen Signals zu beaufschlagen.

Die Empfangselektrode und die Sendelektrode können jeweils elektrisch isoliert vom Handgerät am Handgerät anordenbar sein. Damit können auch elektrische Handgeräte mit einem metallischen Gehäuse mit der erfindungsgemäßen Einrichtung ausgestattet werden, wobei durch die Isolierung ein Einkoppeln des elektrischen Wechselfeldes über das metallische Gehäuse in die Empfangselektrode weitestgehend vermieden bzw. verhindert wird.

Zwischen der Empfangselektrode und dem Gehäuse und/oder zwischen der Sendelektrode und dem Gehäuse kann jeweils eine mit dem Massepotential des elektrischen Handgerätes gekoppelte elektrisch leitfähige S Schicht als elektrisch leitfähige Struktur angeordnet sein, wobei die Fläche der elektrisch leitfähigen Schicht jeweils größer ist als die Fläche der Empfangselektrode und/oder der Sendelektrode. Ein Einkoppeln des elektrischen Wechselfeldes über ein metallisches Gehäuse in die Empfangselektrode kann so noch weiter verringert werden.

Durch die Erfindung bereitgestellt wird auch ein Verfahren zur Detektion eines Umgreifens eines elektrischen Handgerätes durch eine Hand mit einer Detektionseinrichtung, welche zumindest eine Sendeelektrode und zumindest eine Empfangselektrode aufweist, wobei die zumindest eine Sendeelektrode mit einer elektrischen Wechselspannung beaufschlagt wird, sodass an der zumindest einen Sendeelektrode ein elektrisches Wechselfeld emittiert wird, wobei
- beim Umgreifen des Handgerätes mit einer Hand ein erster Anteil des elektrischen Wechselfeldes über die Hand in die Empfangselektrode eingekoppelt wird, und
- der erste Anteil des elektrischen Wechselfeldes in der Empfangselektrode einen ersten elektrischen Strom erzeugt, welcher indikativ für ein Umfassen des Handgerätes ist.

Die Detektionseinrichtung weist zumindest eine mit dem Massepotential des elektrischen Handgerätes gekoppelte elektrisch leitfähige Struktur auf, wobei
- bei Nicht-Umgreifen des Handgerätes ein zweiter Anteil des elektrischen Wechselfeldes in die elektrisch leitfähige Struktur eingekoppelt wird und ein dritter Anteil des elektrischen Wechselfeldes, welcher betragsmäßig kleiner ist als der zweite Anteil, in die Empfangselektrode eingekoppelt wird,
- beim Umgreifen des Handgerätes der dritte Anteil des elektrischen Wechselfeldes betragsmäßig kleiner ist als der erste Anteil des elektrischen Wechselfeldes, und
- der dritte Anteil des elektrischen Wechselfeldes in der Empfangselektrode einen zweiten elektrischen Strom erzeugt, wobei der aus dem ersten elektrischen Strom und dem zweiten elektrischen Strom resultierende Gesamtstrom indikativ für ein Umfassen des Handgerätes ist.

Vorteilhaft ist es, wenn
- ein Einschaltmodus und/oder ein Aktivmodus des Handgerätes herbeigeführt wird, wenn der Gesamtstrom einen vorbestimmten ersten Schwellwert überschreitet; und/oder
- ein Schlafmodus des Handgerätes herbeigeführt wird, wenn der Gesamtstrom einen vorbestimmten zweiten Schwellwert unterschreitet.

Der erste Schwellwert und der zweite Schwellwert können identisch sein. Sie können aber auch verschieden sein.

Die Empfangselektrode kann mit einem kapazitiven Sensor gekoppelt werden, welcher einen Signalgenerator umfasst und dessen Ausgangssignal von der kapazitiven Belastung an der Empfangselektrode abhängig ist, wobei die Sendeelektrode von dem Signalgenerator mit einem Wechselsignal beaufschlagt wird, welches phasenverschobenen zum Signal des Signalgenerators ist.

Das elektrische Handgerät kann zumindest eines aus Mobiltelefon, Eingabemittel für Spielkonsole, mobiler Kleincomputer, Kopfhörer, Hörgerät, Computermaus, und Fernbedienung umfassen.

Bereitgestellt wird auch ein Verfahren zur Detektion eines Umgreifens eines elektrischen Handgerätes durch eine Hand mit einer Detektionseinrichtung, welche zumindest eine Sendeelektrode und zumindest eine Empfangselektrode aufweist, wobei die zumindest eine Sendeelektrode mit einem elektrischen Wechselsignal, vorzugsweise eine elektrische Wechselspannung beaufschlagt wird, sodass an der zumindest einen Sendeelektrode ein elektrisches Wechselfeld emittiert wird, wobei
- beim Umgreifen des Handgerätes mit einer Hand ein erster Anteil des elektrischen Wechselfeldes über die Hand in die Empfangselektrode eingekoppelt wird, und
- der erste Anteil des elektrischen Wechselfeldes in der Empfangselektrode einen ersten elektrischen Strom erzeugt, welcher indikativ für ein Umfassen des Handgerätes ist.

Erfindungsgemäß weist die Detektionseinrichtung zumindest eine mit dem Massepotential des elektrischen Handgerätes gekoppelte elektrisch leitfähige Struktur auf, wobei die elektrisch leitfähige Struktur so relativ zur Sendeelektrode und zur Empfangselektrode angeordnet wird, dass bei Nicht-Umgreifen des Handgerätes ein Einkoppeln des an der Sendeelektrode emittierten elektrischen Wechselfeldes in die Empfangselektrode im Wesentlichen verhindert wird.

Das Verfahren ist vorzugsweise so ausgestaltet, dass
- bei Nicht-Umgreifen des Handgerätes ein zweiter Anteil des elektrischen Wechselfeldes in die elektrisch leitfähige Struktur eingekoppelt wird und ein dritter Anteil des elektrischen Wechselfeldes, welcher betragsmäßig kleiner ist als der zweite Anteil, in die Empfangselektrode eingekoppelt wird,
- beim Umgreifen des Handgerätes der dritte Anteil des elektrischen Wechselfeldes betragsmäßig kleiner ist als der erste Anteil des elektrischen Wechselfeldes, und
- der dritte Anteil des elektrischen Wechselfeldes in der Empfangselektrode einen zweiten elektrischen Strom erzeugt, wobei der Gesamtstrom, welcher aus dem ersten elektrischen Strom und dem zweiten elektrischen Strom resultiert, indikativ für ein Umfassen des Handgerätes ist.

Des Weiteren kann das Verfahren angepasst sein, dass
- ein Einschaltmodus und/oder ein Aktivmodus des Handgerätes herbeigeführt wird, wenn der Gesamtstrom einen vorbestimmten Schwellenwert überschreitet; und/oder
- ein Schlafmodus des Handgerätes herbeigeführt wird, wenn der Gesamtstrom einen vorbestimmten Schwellenwert unterschreitet.

### Kurzbeschreibung der Figuren

Weitere Einzelheiten und Merkmale der Erfindung ergeben sich aus der nachfolgenden Beschreibung in Verbindung mit der Zeichnung. Es zeigt:
- Fig. 1: ein elektrisches Handgerät, welches von einer Hand umgriffen wird, als Erläuterung des Funktionsprinzips der Detektionseinrichtung;
- Fig. 2: den Verlauf von Feldlinien an einem Handgerät, welches auf einer elektrisch nichtleitenden Ablagefläche abgelegt ist;
- Fig. 3: den Feldverlauf an einem Handgerät, welches auf einer elektrisch leitfähigen Ablagefläche abgelegt ist;
- Fig. 4: den zeitlichen Verlauf eines Sensorsignals in Abhängigkeit davon, ob das Handgerät auf einer nichtleitenden oder auf einer leitenden Ablagefläche abgelegt ist bzw. ob das Handgerät von einer Hand umgriffen wird;
- Fig. 5: eine Anordnung der Detektionseinrichtung in dem Handgerät, wobei die mit Massepotential gekoppelte elektrisch leitfähige Struktur auch an der Oberschale des Gehäuses des Handgerätes angeordnet ist;
- Fig. 6: ein Blockschaltbild einer elektrischen Schaltung zur Signalerzeugung und zur Auswertung;
- Fig. 7: eine alternative Ausführungsform der in Fig. 6 gezeigten elektrischen Schaltung;
- Fig. 8: eine weitere Ausführungsform einer elektrischen Schaltung zur Signalerzeugung und zur Auswertung;
- Fig. 9: eine vorteilhafte Ausgestaltung einer Schaltungsanordnung für die Signalerzeugung und die Auswertung;
- Fig. 10: eine Elektrodenanordnung an einem Gehäuse, wobei ein PCB als Massepotential für die Elektrodenanordnung dient;
- Fig. 11: eine mögliche Anordnung der mit dem Massepotential des elektrischen Handgerätes gekoppelten leitfähigen Struktur zur Unterdrückung der Ausbreitung von Feldlinien im Inneren des Gehäuses;
- Fig. 12: eine beispielhafte Elektrodenanordnung an einem Gehäuse mit einem im inneren des Gehäuses angeordneten Stromversorgung, welche als Massepotential dient;
- Fig. 13: eine Elektrodenanordnung an einem Gehäuse mit zusätzlichen Schirmelektroden;
- Fig. 14: eine Elektrodenanordnung an einem Gehäuse mit zusätzlichen Elektroden an dem Gehäuse, welche mit dem Massepotential des elektrischen Handgerätes gekoppelt sind;
- Fig. 15: eine Ausführungsform von Elektroden an einem Metallgehäuse, welches eine Koppelung mit dem Massepotential des Handgeräts aufweist;
- Fig. 16: eine Elektrodenausführung an einem Metallgehäuse, welches keine Koppelung mit dem Massepotential des Handgeräts aufweist;
- Fig. 17: einen Querschnitt durch ein Elektrodenpaket für ein Metallgehäuse ohne Koppelung mit dem Massepotential des Handgeräts;
- Fig. 18: eine weitere Ausgestaltung einer Detektionseinrichtung für ein elektrisches Handgerät zur Detektion eines Umgreifens des Handgeräts durch eine Hand;
- Fig. 19: eine e Detektionseinrichtung mit einer Empfangselektrode und mehreren Sendelektroden;
- Fig. 20: eine beispielhafte Anordnung von zwei Elektroden an einer Gehäuseoberfläche;
- Fig. 21: Verlauf der Feldlinien zwischen zwei Elektroden ohne Annäherung durch eine Hand;
- Fig. 22: Verlauf der Feldlinien zwischen zwei Elektroden bei Annäherung durch eine Hand;
- Fig. 23a - 23c: drei alternative Anordnungen von Sendeelektrode und Empfangselektrode an einer Gehäuseoberfläche;
- Fig. 24a: den Betrieb von zwei Sendeelektroden im Zeitmultiplexverfahren; und
- Fig. 24b: den Betrieb von zwei Sendeelektroden im Frequenzmultiplexverfahren;

### Detaillierte Beschreibung der Erfindung

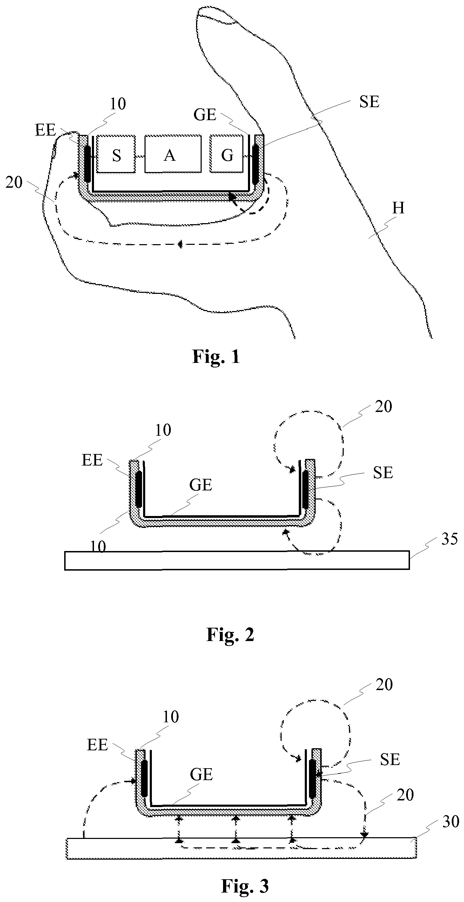

**Fig. 1** zeigt ein elektrisches Handgerät mit einer en Detektionseinrichtung im Querschnitt, wobei das Handgerät von einer Hand H umgriffen wird. An einer Seitenwand des elektrischen Handgerätes ist eine Sendelektrode SE und an einer der einen Seitenwand gegenüber liegenden Seitenwand ist eine Empfangselektrode EE angeordnet. Die Sendeelektrode SE und die Empfangselektrode EE sind dabei an den sich gegenüberstehenden Seitenflächen des Handgerätes so angeordnet, dass bei einem Umgreifen des Gehäuses mit einer Hand beide Elektroden zumindest teilweise von der Hand überdeckt werden.

Die Sendelektrode SE ist mit einem Signalgenerator G gekoppelt, welcher eine niederfrequente elektrische Wechselspannung erzeugt. Die Sendelektrode SE wird mit dieser elektrischen Wechselspannung beaufschlagt bzw. eingeprägt. Dabei bildet sich an der Sendeelektrode SE ein elektrisches Wechselfeld 20 aus. Die von dem Generator G bereitgestellte elektrische Wechselspannung weist eine Frequenz von etwa zwischen 10 kHz und 300 kHz auf. Bevorzugt weist die elektrische Wechselspannung eine Frequenz zwischen 75 kHz und 150 kHz auf.

Wie in Fig. 1 ersichtlich, führt das Umgreifen des Handgerätes durch eine Hand H zu einer kapazitiven Koppelung zwischen der Sendeelektrode SE und der Empfangselektrode EE. Die kapazitive Koppelung zwischen der Sendeelektrode SE und der Empfangselektrode EE ist beim Umgreifen des Handgerätes durch eine Hand größer als eine kapazitive Koppelung ohne ein Umgreifen durch eine Hand bzw. als im abgelegten Zustand des Handgerätes. Ein vollständiges Umgreifen des Handgerätes durch die Hand, d.h. dass die Hand das Handgerät vollständig umgibt, ist nicht notwendig. Es ist ausreichend, wenn die Hand an beiden Seitenflächen d.h. im Bereich der Sendeelektrode bzw. der Empfangselektrode aufliegt, so dass die Hand die Sendeelektrode und die Empfangselektrode zumindest teilweise überdeckt.

Das von der Sendeelektrode SE emittierte elektrische Wechselfeld 20 wird von der Hand H aufgenommen und an die Empfangselektrode weitergeleitet und dort eingekoppelt. Der kapazitive Sensor S, welcher mit der Empfangselektrode gekoppelt ist, empfängt das Signal und führt es einer Auswerteeinrichtung A zu.

Die Flächen der Sensorelektrode und der Empfangselektrode sind vorzugsweise so gewählt, dass sie der Berührfläche der Hand bzw. der Finger an dem Gehäuse 10 im umgriffenen Zustand entsprechen. Insgesamt wird die Detektionseinrichtung an dem elektrischen Handgerät so ausgelegt, dass ohne Umgreifen durch eine Hand H die kapazitive Koppelung zwischen der Sensorelektrode SE und der Empfangselektrode EE minimiert bzw. verhindert wird. Das System wird zusätzlich so ausgelegt, dass auch eine kapazitive Koppelung zwischen der Sensorelektrode SE und der Empfangselektrode EE im Inneren des Gehäuses reduziert bzw. verhindert wird, wie mit Bezug auf die nachfolgenden Figuren näher erläutert wird.

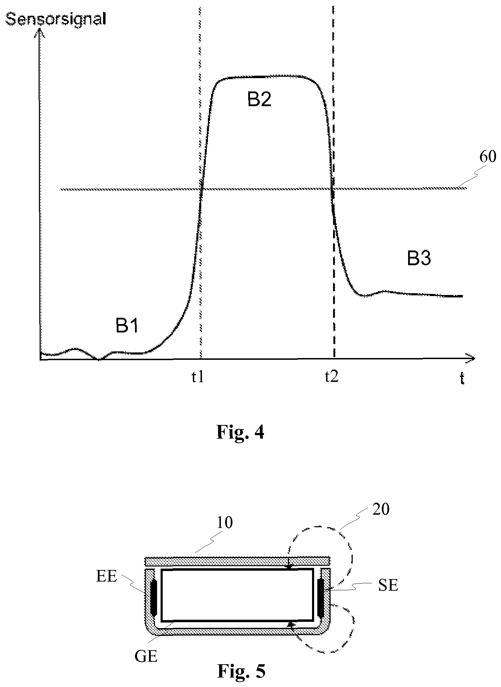

Weil das Umgreifen des elektrischen Handgeräts durch eine Hand H zu einer starken kapazitiven Koppelung zwischen der Sendeelektrode SE und der Empfangselektrode EE führt und weil die kapazitive Koppelung zwischen diesen beiden Elektroden im abgelegten Zustand bzw. bei Nicht-Umgreifen durch eine Hand H sehr klein ist bzw. fehlt, ist eine besonders zuverlässige Detektion eines Umgreifens möglich, da das Umgreifen durch eine Hand zu einem starken Anstieg der kapazitiven Koppelung führt, was wiederum zu einem starken Anstieg des an der Empfangselektrode EE erzeugten elektrischen Stroms führt, wie mit Bezug auf Fig. 4 näher erläutert wird.

Wird das elektrische Handgerät abgelegt, also nicht von einer Hand H umgriffen, so fehlt die starke kapazitive Koppelung zwischen der Sendeelektrode SE und der Empfangselektrode EE, d.h. an der Empfangselektrode EE wird nur ein sehr kleiner Anteil des an der Sendeelektrode SE abgestrahlten elektrischen Wechselfeldes eingekoppelt. Dadurch kann ein Nicht-Umgreifen des elektrischen Handgerätes sicher vom Umgreifen des elektrischen Handgerätes unterschieden werden.

**Fig. 2** zeigt ein elektrisches Handgerät im Querschnitt, welches auf einer elektrisch nicht leitenden Oberfläche 35 abgelegt ist. Im Inneren des Gehäuses 10 des elektrischen Handgerätes ist eine elektrisch leitfähige Struktur GE angeordnet, welche mit dem Massepotential des elektrischen Handgerätes gekoppelt ist. Die elektrisch leitfähige Struktur GE ist dazu vorgesehen, die kapazitive Koppelung zwischen der Sendeelektrode SE und der Empfangselektrode EE zu verringern bzw. ein Ausbreiten der elektrischen Feldlinien 20 von der Sendeelektrode SE bis zur Empfangselektrode EE weitestgehend zu verhindern, in dem das an der Sendeelektrode SE abgestrahlte elektrische Wechselfeld 20 durch die elektrisch leitfähige Struktur GE größtenteils bereits in der näheren Umgebung der Sendeelektrode SE durch die Struktur GE absorbiert wird, d.h. das an der Sendeelektrode SE abgestrahlte elektrische Wechselfeld 20 wird in die elektrisch leitfähige Struktur GE einkoppelt. In der Empfangselektrode EE fließt dann nahezu kein Strom, was indikativ dafür ist, dass sich das Handgerät in einem abgelegten Zustand befindet bzw. nicht von einer Hand H umgriffen wird.

In **Fig. 3** ist ein elektrisches Handgerät gezeigt, das auf einer elektrisch leitfähigen Ablagefläche 30 abgelegt ist. Beim Ablegen des elektrischen Handgerätes auf einer elektrisch leitfähigen Ablagefläche besteht die Gefahr, dass das an der Sendelektrode SE emittierte elektrische Wechselfeld 20 über die elektrisch leitfähige Ablagefläche an der Empfangselektrode EE eingekoppelt wird und dort einen elektrischen Strom erzeugt, welcher im Wesentlichen dem elektrischen Strom entspricht, der beim Umgreifen des Handgerätes durch eine Hand in der Empfangselektrode EE erzeugt wird.

Um eine Einkoppelung des elektrischen Wechselfeldes über eine elektrisch leitfähige Ablagefläche an der Empfangselektrode EE weitestgehend zu vermeiden, werden die Sendeelektrode SE und die Empfangselektrode EE erfindungsgemäß jeweils an einer Seitenwandung des Gehäuses 10 des elektrischen Handgerätes angeordnet. Zusätzlich wird die mit dem Massepotential des elektrischen Handgerätes gekoppelte elektrisch leitfähige Struktur GE so ausgestaltet, dass ein Großteil des in die elektrisch leitfähige Ablagefläche 30 eingekoppelten elektrischen Wechselfeldes 20 zudem in die elektrisch leitfähige Struktur GE eingekoppelt wird. Eine daraus resultierende Resteinkoppelung des elektrischen Wechselfeldes in die Empfangselektrode EE ist sehr klein, so dass auf Grund der Restkoppelung in der Empfangselektrode EE nur ein sehr geringer Strom fließt, wie mit Bezug auf Fig. 4 näher erläutert wird.

Die Anordnung der Sendeelektrode SE und der Empfangselektrode EE an der Seitenwandung des elektrischen Handgerätes sowie die Ausgestaltung der elektrisch leitfähigen Struktur GE gewährleisten, dass eine Unterscheidung eines Handgerätes im abgelegten Zustand auf einer elektrisch leitfähigen Ablagefläche von einem Umgreifen durch eine Hand H sicher bewerkstelligt werden kann.

**Fig. 4** zeigt den zeitlichen Verlauf eines Sensorsignals an der Empfangselektrode EE in unterschiedlichen Anwendungsszenarien. Das Sensorsignal kann beispielsweise durch den in der Empfangselektrode EE fließenden Strom repräsentiert werden.

Bis zum Zeitpunkt t1 ist das elektrische Handgerät auf einer elektrisch nicht leitenden Ablagefläche abgelegt. Aufgrund der sehr geringen bzw. nicht vorhanden kapazitiven Koppelung zwischen der Sendeelektrode und der Empfangselektrode bei einem Handgerät, welches auf einer elektrisch nicht leitenden Ablagefläche abgelegt ist, fließt in der Empfangselektrode EE nur ein sehr geringer Strom.

Wird das Handgerät nun in der Hand gehalten bzw. von der Hand umgriffen, so dass die Hand die an dem Gehäuse angeordneten Elektroden SE und EE zumindest teilweise überdeckt, führt dies aufgrund der nunmehr sehr starken kapazitiven Koppelung zwischen der Sendelektrode SE und der Empfangselektrode EE zu einem sprunghaften Anstieg des in der Empfangselektrode EE fließenden elektrischen Stromes. Der Signalverlauf, welcher dem Handgerät im umgriffenen Zustand entspricht ist zwischen den Zeitpunkten t1 und t2 aufgetragen.

Wird nun das elektrische Handgerät zum Zeitpunkt t2 auf eine elektrisch leitfähige Ablagefläche abgelegt verringert sich die kapazitive Koppelung zwischen der Sendelektrode SE und der Empfangselektrode EE sprunghaft. Aufgrund einer gewissen (sehr geringen) kapazitiven Koppelung zwischen der Sendeelektrode SE und der Empfangselektrode EE über die elektrisch leitfähige Ablagefläche kann der Strom, welcher in der Empfangselektrode EE fließt, bei einem auf einer elektrisch leitfähigen Ablagefläche abgelegten Handgerät größer sein als bei einem auf einer elektrisch nicht leitfähigen Ablagefläche abgelegten Handgerät.

Überschreitet das Sensorsignal bzw. der in der Empfangselektrode fließende elektrische Strom eine vorbestimmte Detektionsschwelle 60 kann in dem Handgerät eine vorbestimmte Aktion ausgelöst werden. Ebenso kann bei Unterschreiten der Detektionsschwelle 60 eine weitere vorbestimmte Aktion in dem Handgerät ausgelöst werden. Beispielsweise kann bei Überschreiten der Detektionsschwelle 60, was ein Umgreifen des Handgerätes durch eine Hand der Fall ist, das Handgerät von einem sogenannten Schlafmodus in einen Aktivmodus übergeführt werden. In dem Aktivmodus kann die volle Funktionsfähigkeit bereitgestellt werden.

Bei Unterschreiten der Detektionsschwelle 60 kann das Handgerät von dem Aktivmodus wieder in den Schlafmodus übergeführt werden, wobei in dem Schlafmodus beispielsweise sämtliche nicht benötigten Funktionen des Handgerätes deaktiviert werden bzw. nicht benötigte elektrische Baugruppe nicht mit Energie versorgt werden.

In einer Anwendung der Detektionseinrichtung kann das Unterschreiten der Detektionsschwelle dazu genutzt werden, die Anzeigeeinrichtung, beispielsweise eines Mobiltelefons, vollständig abzuschalten. Die Detektionseinrichtung ermöglicht es also das elektrische Handgerät nur dann in einen Aktivmodus überzuführen, wenn es tatsächlich von einer Hand umgriffen wird. Durch die erfindungsgemäße Anordnung der Sensorelektrode und der Empfangselektrode sowie der mit dem Massepotential des elektrischen Handgerätes gekoppelten leitfähigen Struktur GE werden auch zuverlässig Fehlinterpretation vermieden, welche im Stand der Technik dann auftreten konnten, wenn das elektrische Handgerät auf einer elektrisch leitfähigen Ablagefläche abgelegt wurde.

Zur einfacheren Darstellung wird mit Bezug auf Fig. 4 eine feste Detektionsschwelle 60 angenommen. In der Praxis kann jedoch eine gleitende Detektionsschwelle 60 vorgesehen sein, welche sich in bestimmten Grenzen an die Messewerte bzw. an das Sensorsignal adaptiert. Es können auch mehrere unterschiedliche Detektionsschwellen vorgesehen sein, dessen Überschreiten bzw. Unterschreiten jeweils unterschiedliche Aktionen auslöst. Es kann eine zweite, hier nicht gezeigte Detektionsschwelle vorgesehen sein, welche unterhalb der hier gezeigten Detektionsschwelle 60 liegt. Ein Überschreiten der unteren Detektionsschwelle kann beispielsweise dazu führen, dass in dem elektrischen Handgerät ein Initialisierungsvorgang durchgeführt wird, so dass beim Überschreiten der oberen Detektionsschwelle 60 das elektrische Handgerät bereits voll funktionsfähig zur Verfügung steht.

**Fig. 5** zeigt einen Querschnitt durch ein elektrisches Handgerät mit einer Detektionseinrichtung. In der in Fig. 5 gezeigten Ausführungsform ist die mit dem Massepotential des elektrischen Handgerätes gekoppelte elektrisch leitfähige Struktur GE auch im Bereich der Oberschale des Gehäuses 10 bzw. der Oberseite des Gehäuses angeordnet, so dass es für eine sichere Detektion des Umgreifens einer Hand bzw. des Ablegens des elektrischen Handgerätes auf einer Ablagefläche nicht von Bedeutung ist, ob das elektrische Handgerät mit der Unter- oder Oberseite auf der Ablagefläche abgelegt wird. Anstelle einer wie in Fig. 5 gezeigten umlaufenden elektrisch leitfähigen Struktur kann für die Oberschale des Gehäuses 10 auch eine zweite mit dem Massepotential des elektrischen Handgerätes gekoppelte elektrische leitfähige Struktur GE vorgesehen werden.

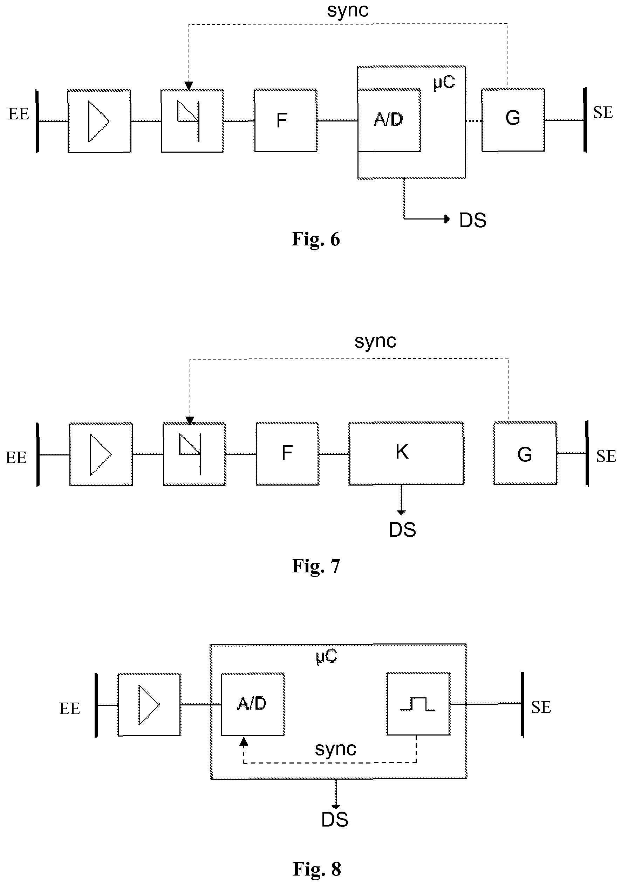

In den Fig. 6 bis 9 werden mögliche Konzepte zur Erzeugung eines Signals, mit welchem die Sendeelektrode SE beaufschlagt wird, und zur Auswertung des an der Empfangselektrode EE anliegenden Signals dargestellt.

**Fig. 6** zeigt eine Auswerteschaltung mit einem Spitzenwert- bzw. Synchrongleichrichter und einem Mikrocontroller. Ein Generator G erzeugt ein elektrisches Wechselsignal, welches an der Elektrode SE beaufschlagt wird. Der Generator G kann mit dem Mikrocontroller gekoppelt sein. Das an der Empfangselektrode EE anliegende Wechselsignal, d.h. das dort eingekoppelte elektrische Wechselfeld wird einer Gleichrichtereinrichtung mit nachfolgenden Filter F zugeführt. Das gleichgerichtete und mit dem Filter geglättete Gleichsignal wird einem Analog-Digital-Wandler zugeführt. Der Analog-Digital-Wandler kann Bestandteil des Mikrocontrollers sein. Der Mikrocontroller ist ausgestaltet, dass von dem Analog-Digital-Wandler bereitgestellte digitale Signal auszuwerten um ein Umgreifen des Handgerätes durch eine Hand zu detektieren. Das Ergebnis der Auswertung kann als (digitales) Detektorsignal DS von dem Mikrocontroller zur weiteren Verarbeitung im elektronischen Handgerät bereitgestellt werden. Der Mikrocontroller kann auch vorgesehen sein den Signalgenerator G zu steuern.

**Fig. 7** zeigt eine alternative Ausführungsform der in Fig. 6 gezeigten elektrischen Schaltung zur Signalerzeugung und Auswertung. Anstelle dieses in Fig. 6 gezeigten Mikrocontrollers mit dem Analog-Digital-Wandler ist ein Komparator vorgesehen, welcher wie der Mikrocontroller nach Fig. 6 ein (digitales) Detektorsignal DS zur weiteren Verarbeitung in dem elektrischen Handgerät bereitstellt.

**Fig. 8** zeigt eine weitere Schaltung zur Signalerzeugung und zur Auswertung. Anstelle eines Gleichrichtens des an der Empfangselektrode EE anliegenden Signals findet hier eine Auswertung statt, indem das an der Empfangselektrode anliegende Signal direkt abgetastet wird. Hierzu wird das an der Empfangselektrode anliegende Wechselsignal zunächst einer Verstärkung zugeführt. Das verstärkte Signal wird einem Analog-Digital-Wandler zugeführt, welcher Bestandteil des Mikrocontrollers sein kann. Der Mikrocontroller kann einen Rechteckgenerator umfassen, welcher ein Signal bereitstellt, mit welchem die Sendeelektrode SE beaufschlagt wird. Zur Verbesserung der EMV-Verträglichkeit kann das von dem Mikrocontroller bereitgestellte Rechtecksignal in ein Signal mit geringerer Bandbreite, z.B. in ein Signal mit einer Signalform ähnlich einer Sinusform, gewandelt werden.

In den in den Fig. 6 bis 8 gezeigten Ausführungsformen einer Signalerzeugung und Auswertung kann die Auswertung mit dem Signalgenerator synchronisiert werden, was in den Fig. 6 bis 8 mit "synch" angegeben ist. Die Synchronisierung ist optional. Mit der Synchronisierung kann bei den in den Fig. 6 und 7 gezeigten Ausführungen anstelle einer Spitzenwertgleichrichtung eine Synchrongleichrichtung erfolgen, was hinsichtlich einer verbesserten Störresistenz vorteilhaft ist. Mit Bezug auf Fig. 8 ist das Prinzip der Synchrongleichrichtung auf digitaler Basis gezeigt, wobei das Sample-and-Hold-Glied des Analog-Digital-Wandlers synchron zum Signal des Signalgenerators betrieben wird.

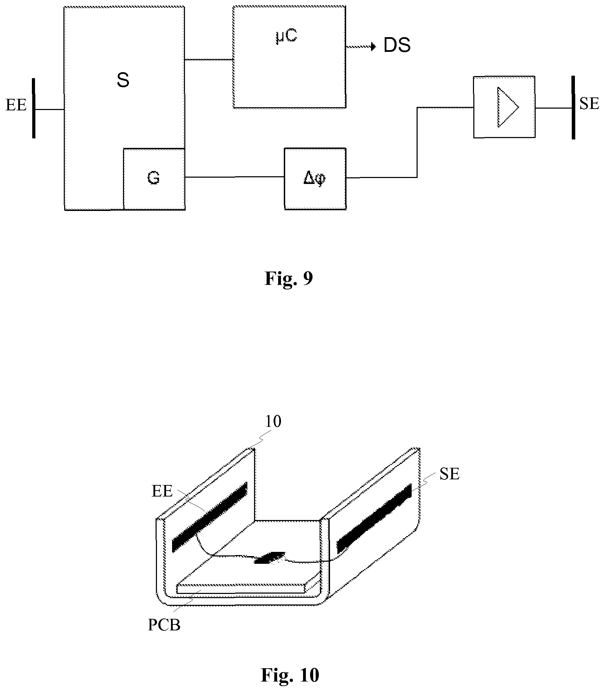

**Fig. 9** zeigt eine Schaltungsanordnung für eine Signalerzeugung und eine Auswertung, welche auf einen kapazitiven Sensor S beruht. Der kapazitive Sensor S, dessen Sensorelektrode gleichzeitig die Empfangselektrode EE der Detektionseinrichtung darstellt, arbeitet nach einem Last-Verfahren, d.h. dass das Ausgangssignal des kapazitiven Sensors S von der kapazitiven Belastung der Sensorelektrode bzw. der Empfangselektrode EE abhängig ist. Ob der kapazitive Sensor S eine Amplitudenänderung, eine Frequenzänderung oder eine Phasenlage des Sensorsignals auswertet, ist dabei nicht von Bedeutung.

Der Kapazitätssensor S alleine kann allerdings nicht feststellen, ob das Objekt, welches eine Belastung an der Sensorelektrode bzw. an der Empfangselektrode EE bewirkt eine Hand ist, die das Handgerät umgreift, oder ob das Handgerät mit jener Seite auf einer Ablagefläche abgelegt ist an welcher sich die Sensorelektrode bzw. die Empfangselektrode EE befindet. Gemäß der Erfindung ist an der Gehäusewandung, welche sich gegenüber der Gehäusewandung befindet, an welcher die Empfangselektrode EE angeordnet ist, eine Sendeelektrode SE vorgesehen. Das von dem Signalgenerator des kapazitiven Sensors S bereitgestellte Signal wird verstärkt und der Sendelektrode SE zugeführt. Das der Sendelektrode SE zugeführte Signal kann gegebenenfalls in seiner Phase verschoben werden, in dem zwischen dem Signalgenerator G und der Sendeelektrode SE ein Phasenschieber vorgesehen ist. An der Sendeelektrode SE wird dann ein elektrisches Wechselfeld emittiert, dessen Phasenlage verschoben zur Phasenlage des vom Signalgenerator G bereitgestellten Signals ist.

Umgreift eine Hand das elektrische Handgerät, so wird erfindungsgemäß das an der Sendelektrode SE emittierte elektrische Wechselfeld über die Hand an die Sensorelektrode bzw. die Empfangselektrode EE weitergeleitet und an dieser eingekoppelt. Je nach Phasenlage des an der Sendelektrode SE emittierten elektrischen Wechselfeldes ergeben sich dabei zwei unterschiedliche Effekte:
- bei großem Phasenversatz (90° bis 270°) entsteht eine Gegenkoppelung, so dass die an der Empfangselektrode EE gemessene Kapazität stark ansteigt. Eine das elektrische Handgerät umgreifende Hand bewirkt dadurch eine wesentlich stärkere Kapazitätserhöhung an der Empfangselektrode EE als ohne die Sendelektrode SE.
- Bei geringem Phasenversatz (0° bis 90° und 207° bis 360°) entsteht eine Mitkoppelung. Eine Mitkoppelung hat den Effekt, dass beim Umgreifen des elektrischen Handgerätes durch eine Hand die Kapazität an der Empfangselektrode EE stark reduziert wird. Dadurch kann ein Objekt, welches sich an der Sensorelektrode bzw. an der Empfangselektrode EE befindet besonders einfach von einem Umgreifen des Handgeräts durch eine Hand unterschieden werden. Ein Objekt an der Sensorelektrode bzw. an der Empfangselektrode EE führt also zu einer Kapazitätserhöhung, während das Umgreifen des Handgerätes durch eine Hand zu einer Kapazitätsverringerung führt.

Der Kapazitätssensor S kann ein digitales Ausgangssignal zur Verfügung stellen, welches einem Mikrocontroller zur Auswertung zugeführt wird. Der Kontroller kann wiederum ein (digitales) Detektorsignal DS bereitstellen, welches zur weiteren Verarbeitung dem elektrischen Handgerät zur Verfügung gestellt wird.

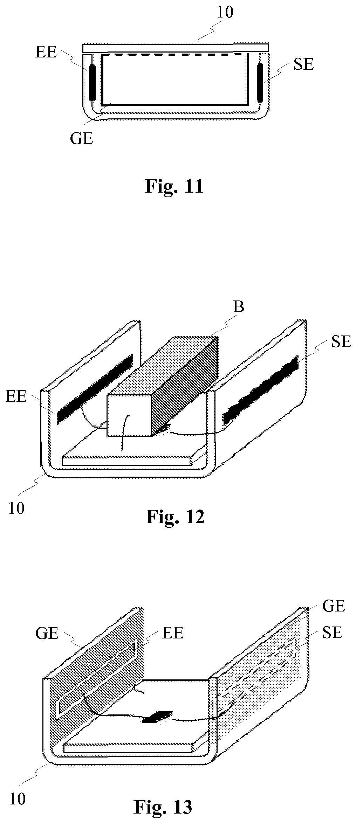

Die Anordnung der Sensorelektrode SE und der Empfangselektrode EE zueinander sowie der mit dem Massepotential des elektrischen Handgerätes gekoppelten elektrischen leitfähigen Struktur wird so gewählt, dass eine möglichst geringe kapazitive Koppelung zwischen der Sende- und der Empfangselektrode auf direktem Weg, also nicht über die Hand, erreicht wird. Dies wird in erster Linie durch die mit dem Massepotential gekoppelte elektrisch leitfähige Struktur sichergestellt. Um dies im Inneren des Gehäuses 10 zu erreichen, ist eine mit dem Massepotential des elektrischen Handgerätes gekoppelte elektrische leitfähige Struktur im Inneren des Gehäuses vorgesehen, wie mit Bezug auf Fig. 11 gezeigt. An der Oberschale des Gehäuses 10 kann zusätzlich eine zweite mit dem Massepotential des elektrischen Gerätes gekoppelte elektrisch leitfähige Struktur vorgesehen sein.

Alternativ zum Hinzufügen einer elektrisch leitfähigen Struktur, welche mit dem Massepotential gekoppelt ist, können auch bestehende Komponenten des elektrischen Handgerätes verwendet werden. Ein Beispiel hierzu ist in Fig. 12 gezeigt, wo beispielsweise eine Batterie B, welche mit dem Massepotential des elektrischen Handgerätes gekoppelt ist, verwendet wird, um ein Ausbreiten der Feldlinien im Inneren des Gehäuses 10 zumindest teilweise zu unterdrücken.

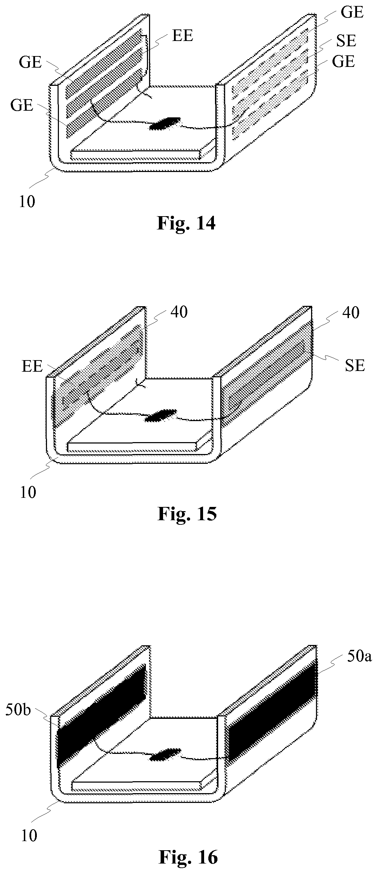

**Fig. 13** **und** **14** zeigen jeweils ein Gehäuse 10 an dessen Seitenwandung jeweils eine Sendelektrode und eine Empfangselektrode angeordnet ist, welche jeweils von einer Elektrodenstruktur umgeben sind, welche mit dem Massepotential des Handgerätes gekoppelt sind. Der Einfluss elektrisch leitfähiger Objekte in der Umgebung des Handgerätes kann so reduziert werden. Die Hand muss jedoch gezielter auf der Sende- und Empfangselektrode platziert werden.

Fig. 15 und 16 zeigen Elektrodenausführungen, wie sie zur Anordnung der Elektroden SE und EE an elektrischen Handgeräten mit einem Metallgehäuse verwendet werden können.

In **Fig. 15** ist ein Metallgehäuse 10 eines Handgerätes gezeigt, welches mit dem Massepotential des elektrischen Handgerätes gekoppelt ist. Die Elektroden SE und EE werden hier isoliert vom Metallgehäuse 10 aufgebracht.

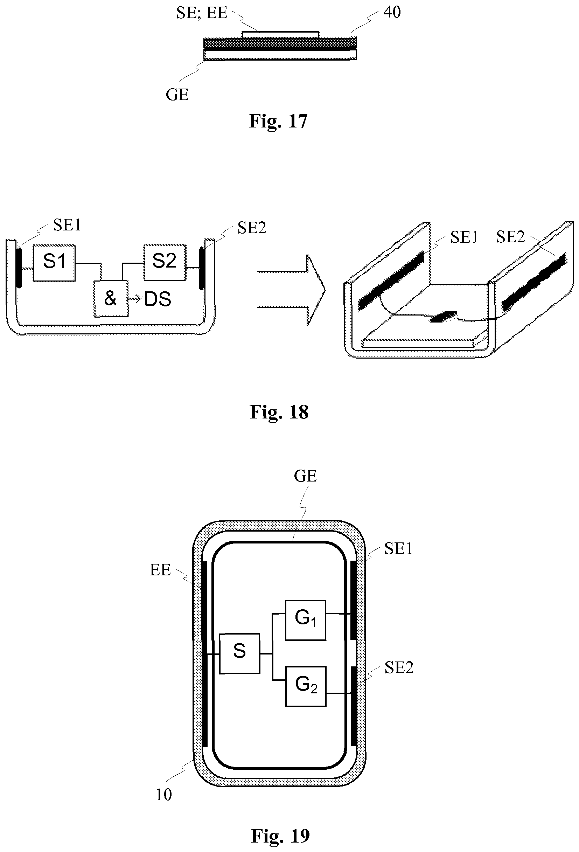

**Fig. 16** zeigt ein Metallgehäuse 10, welches nicht mit dem Massepotential des elektrischen Handgerätes gekoppelt ist. Hier wird zusätzlich zwischen der Elektrode SE bzw. EE und dem Metallgehäuse 10 eine mit dem Massepotential des elektrischen Handgerätes gekoppelte elektrisch leitfähige Schicht aufgebracht. Die elektrisch leitfähige Schicht ist isoliert zur Elektrode und isoliert zum Metallgehäuse 10 angeordnet, wie in **Fig. 17** dargestellt. Die elektrisch leitfähige Struktur GE ist dabei vorzugsweise größer als die Elektrode, um eine Einkoppeln des elektrischen Wechselfeldes von der Sendeelektrode SE über das Metallgehäuse 10 in die Empfangselektrode EE weitestgehend zu verhindern.

**Fig. 18** zeigt eine Lösung zur Detektion eines Umgreifens eines Handgerätes durch eine Hand, bei welcher zwei kapazitive Sensoren S1 und S2 vorgesehen sind. Die jeweiligen Sensorelektroden SE1 und SE2 werden jeweils an einer Seitenwandung des elektrischen Handgerätes angeordnet. Die Ausgangssignale der beiden kapazitiven Sensoren S1, S2 werden logisch UND-verknüpft. Damit kann ausgewertet werden, ob sowohl die Kapazität der linken Elektrode SE1 als auch die Kapazität der rechten Elektrode S2 größer als normal ist. Ist dies der Fall, kann davon ausgegangen werden, dass das elektrische Handgerät von einer Hand umgriffen wird.

**Fig. 19** zeigt eine weitere Ausgestaltung einer Detektionseinrichtung für ein elektrisches Handgerät. In der in Fig. 19 gezeigten Ausgestaltung sind an einer Seitenwandung des Handgerätes zwei voneinander getrennte Sendelektroden SE1 und SE2 angeordnet. An der dieser Seitenwandung gegenüberliegenden Seitenwandung des Handgerätes ist eine Empfangselektrode EE angeordnet. Gemäß einer Ausgestaltung der Erfindung kann für jede Sendeelektrode SE1, SE2 jeweils ein Signalgenerator G1 und G2 bereitgestellt werden, welche jeweils ein Signal unterschiedlicher Frequenz bereitstellen. Die Sendeelektroden S1 und S2 werden also jeweils mit einem Signal unterschiedlicher Frequenz beaufschlagt.

Beim Umfassen des elektrischen Handgerätes durch eine Hand werden die an den Sendelektroden SE1 und SE2 abgestrahlten elektrischen Wechselfelder, welche eine unterschiedliche Frequenz aufweisen, über die Hand an die gemeinsame Empfangselektrode EE eingekoppelt. Die mit der Empfangselektrode gekoppelte Sensoreinheit beziehungsweise Auswerteeinrichtung kann so ausgestaltet sein, dass sie mittels einer Frequenzanalyse die verschiedenen Frequenzanteile trennen kann und den entsprechenden Sendelektroden zuordnen kann. Damit kann zusätzlich zur Detektion, ob das Handgerät von einer Hand umfasst wird, auch detektiert werden in welchem Bereich das Handgerät von einer Hand umgriffen wird.

Alternativ können anstelle einer einzelnen Empfangselektrode EE auch mehrere Empfangselektroden vorgesehen sein, wobei vorzugsweise einer Empfangselektrode jeweils eine Sendeelektrode zugeordnet ist. Ebenfalls ist es möglich, mehrere Empfangselektroden vorzusehen und lediglich eine gemeinsame Sendelektrode. Mit mehreren Sendelektroden und/oder mehreren Empfangselektroden können unterschiedliche Arten des Umgreifens eines Handgerätes detektiert werden. In einer Ausführungsform kann beispielsweise eine erste Sendeelektrode an der Seitenwandung des Handgerätes angeordnet sein und eine zweite Sendeelektrode an der Oberseite des Handgerätes, so dass beispielsweise, falls es sich bei dem Handgerät um ein Mobiltelefon handelt, auch unterschieden werden kann, ob das Mobiltelefon von einer Hand umgriffen wird und ob das Mobiltelefon am Ohr gehalten wird.

In allen der hier gezeigten Ausführungsformen können die Elektroden auf der Innenseite des Gehäuses angeordnet werden. Ebenfalls können die Elektroden auf der Außenseite des Gehäuses angebracht werden, was allerdings hinsichtlich der mechanischen Beanspruchung nachteilig ist.

Die Elektroden können als leitfähige Struktur, beispielsweise in Form einer leitfähigen Lackschicht realisiert werden.

Das Handgerät kann beispielsweise ein Mobiltelefon oder eine Computermaus sein, wobei das Mobiltelefon oder die Computermaus nach dem Umgreifen durch eine Hand von einem Schlafmodus in einen Aktivmodus und nach dem Entfernen der Hand von dem Aktivmodus in dem Schlafmodus umgeschaltet werden können.

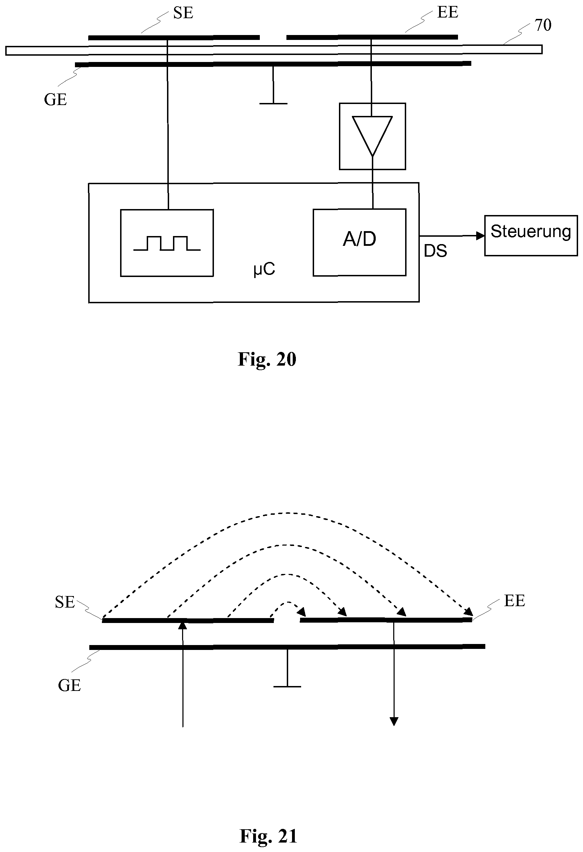

**Fig. 20** zeigt beispielhaft eine alternative Anordnung von zwei Elektroden an einer Gehäuseoberfläche. An einer Gehäuseoberfläche 70, welche aus einem elektrisch nicht leitendem Material besteht, ist eine Sendeelektrode SE und eine Empfangselektrode EE angeordnet. Unterhalb der elektrisch nicht leitenden Oberfläche 70 ist eine weitere Elektrode GE angeordnet, welche mit dem Massepotenzial des elektrischen Handgerätes gekoppelt ist. Die Sendeelektrode SE und die Empfangselektrode EE können beispielsweise eine Fläche von einigen mm² bis einigen cm² betragen. Die Auswahl der konkreten Größe der Elektroden SE, EE hängt von dem zur Verfügung stehenden Platz an der Oberfläche des Gehäuses des elektrischen Handgerätes ab. Die Sensorelektrode SE und die Empfangselektrode EE können sehr nahe zueinander an der elektrisch nicht leitenden Oberfläche 70 angeordnet werden. Beispielsweise kann der Abstand zwischen der Sendeelektrode SE und der Empfangselektrode EE ein mm bis mehrere mm betragen.

Die Sendeelektrode SE und die Empfangselektrode EE sind jeweils mit einem Mikrocontroller µC gekoppelt. Der Mikrocontroller µC ist in der hier gezeigten Ausführungsform so ausgestaltet, dass er ein Rechtecksignal bereit stellt, mit welchem die Sendeelektrode SE beaufschlagt wird. Das Rechtecksignal weist bevorzugt eine Frequenz zwischen 10 und 300 kHz auf. Die Amplitude des Rechtecksignals kann einige Volt betragen. Das Rechtecksignal ist spannungsgeprägt, was bedeutet, dass sich eine kapazitive Belastung an der Sendeelektrode SE nicht auf den Signalverlauf auswirkt. Die Frequenz und/oder das Tastverhältnis des Rechtecksignals können verändert werden, was beispielsweise mit Hilfe des Mikrocontrollers µC geschehen kann. Alternativ kann die Sendeelektrode SE auch mit einem sinusförmigen Signal beaufschlagt werden.

Die Empfangselektrode EE ist mit dem Eingang eines Signalverstärkers gekoppelt. Der Signalverstärker misst den Strom, welcher in der Empfangselektrode EE gegen das Massepotenzial des elektrischen Handgerätes fließt. Die elektrische Größe am Ausgang des Signalverstärkers ist eine Spannung. Der Peak-to-Peak-Wert der relevanten Signalinformation am Ausgang des Signalverstärkers, welcher sich von der Sendeelektrode SE über die Empfangselektrode EE einstellt, verhält sich proportional zu den Änderungen des Signals an der Sendeelektrode SE. Als Signalverstärker kann z.B. ein Transimpedanzverstärker vorgesehen sein.

Das an dem Ausgang des Signalverstärkers anliegende Signal wird dem Mikrocontroller µC zugeführt, welcher die Stärke der relevanten Signalinformation messen und auswerten kann. Hierzu kann ein A/D-Wandler vorgesehen sein. Anhand des gemessenen bzw. ausgewerteten Signals kann der Mikrocontroller µC nun eine Entscheidung treffen, welche Informationen DS einer das Handgerät steuernden Steuerungseinrichtung zugeführt werden.

Mit Bezug auf die nachfolgenden Fig. 21 bis 23c wird die Auslegung der Elektroden SE und EE beschrieben, um eine größtmögliche Empfindlichkeit bezogen auf eine Annäherung einer Hand an die Elektroden und eine bestmögliche Unempfindlichkeit bezogen auf elektrische und physikalische Störgrößen zu erreichen.

**Fig. 21** zeigt einen Verlauf der Feldlinien zwischen der Sendeelektrode SE und der Empfangselektrode EE bei Fehlen einer sich an die Elektroden annähernde Hand.

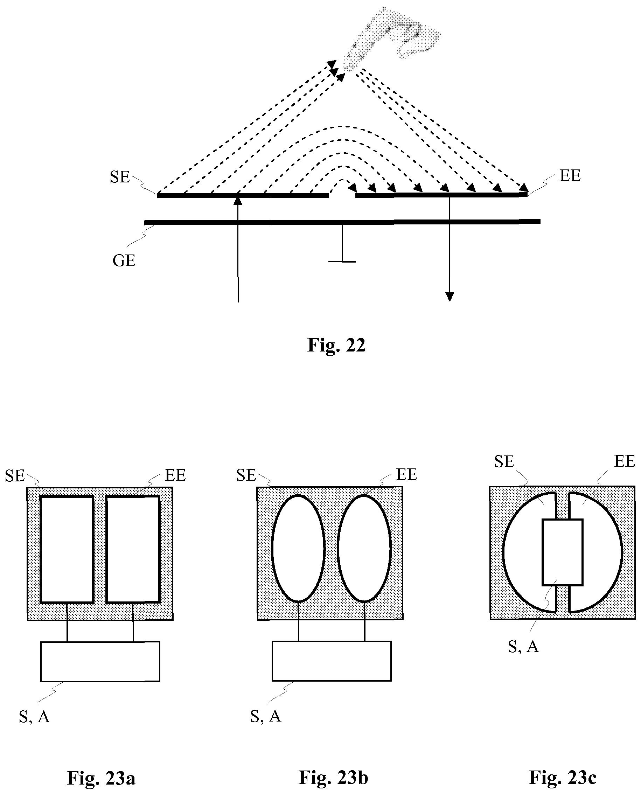

**Fig. 22** zeigt den Verlauf der Feldlinien von der Sendeelektrode SE zur Empfangselektrode EE bei einem sich annähernden Finger an die Elektroden. Aus den Fig. 21 und 22 ist ersichtlich, dass die Anzahl der Feldlinien zwischen der Sendeelektrode und der Empfangselektrode EE bei einem sich annähernden Finger bzw. einer Hand größer ist als bei einem Fehlen eines Fingers bzw. einer Hand an den Elektroden. Hieraus folgt, dass der in der Empfangselektrode EE fließende Strom nach Fig. 22 größer ist als der in der Empfangselektrode EE nach Fig. 21 fließende Strom. Ebenfalls folgt hieraus, dass mit stetiger Annäherung des Fingers bzw. der Hand an die Elektroden der Strom, welcher in der Empfangselektrode fließt, ebenfalls stetig zunimmt.

Die in den Fig. 20 bis 22 gezeigte Sensoreinrichtungen sind so auszulegen, dass eine möglichst kleine absolute Änderung des Stromes in der Empfangselektrode EE detektiert werden kann. Das Limit für die kleinste erkennbare bzw. detektierbare Änderung ist durch die Auflösung bzw. die Konvertertiefe des in dem Mikrocontroller µC vorhandenen Analog-Digital-Wandlers festgelegt.

Um aus einer kleinen relativen Stromänderung in der Empfangselektrode EE ein möglichst großes Abbild in einen absoluten Wert zu erzeugen, muss der Strom in der Empfangselektrode EE bereits ohne eine Annäherung durch eine Hand an die Elektroden (vgl. Fig. 21) an seinem oberen vertretbaren Limit liegen. Das Elektrodendesign der Sendeelektrode SE und der Empfangselektrode EE ist daher so zu wählen, dass zwischen den beiden Elektroden bereits ohne Annäherung eines Fingers bzw. einer Hand eine hohe kapazitive Grundkoppelung besteht. Inverse Feldströme sollen nach Möglichkeit vermieden werden.

Das Übertragungsverhältnis der Spannung an der Sendeelektrode SE zu dem Strom in der Empfangselektrode EE kann mit dem (komplexen) Leitwert (Transadmittanz *Gv*) beschrieben werden. Das Übertragungsverhältnis des Stromes am Eingang des Signalverstärkers, d.h. der Strom, welcher in der Empfangselektrode EE fließt, zu der Spannung an dem Ausgang des Signalverstärkers kann mit einem (komplexen) Widerstand (Transimpedanz *Rv*) beschrieben werden. Durch die Kombination, d.h. die Verkettung dieser beiden Übertragungsverhältnisse *Gv* und *Rv* ist die Ausgangsgröße an dem Signalverstärker von der gleichen Art wie die Eingangsgröße, mit welcher die Sendeelektrode SE beaufschlagt wird, hier also eine Spannung.

Versuche haben gezeigt, dass eine besonders gute Annäherungsdetektion erreicht wird, wenn das Produkt aus dem Betrag der Transadmittanz und dem Betrag der Transimpendanz (|*Gv*|·|*Rv*|) zwischen 0,7 und 0,8 liegt. Das bedeutet, dass sich der Signalverstärker nahezu in Vollaussteuerung befindet. Vorteilhaft ist es, den Betrag der Transadmittanz möglichst groß zu wählen. Dies kann dadurch erreicht werden, indem die Elektrodenflächen der Elektroden SE und EE jeweils möglichst groß gewählt werden. Damit kann der Betrag der Transimpendanz möglichst klein werden.

Ist das Produkt aus dem Betrag der Transadmitanz und dem Betrag der Transimpendanz nicht für alle Geräte eines Produktes identisch, etwa aufgrund von Umwelteinflüssen, können Abweichungen, beispielsweise durch Variation der Frequenz des Signalgenerators korrigiert werden.

Um Detektionsschwellwerte zuverlässig und dynamisch in einer Sensoreinrichtung festlegen zu können, ist es vorteilhaft, den resultierenden Feldstrom künstlich mit Hilfe einer reduzierten Erregung zu verkleinern, was vorteilhafter Weise dann vorgenommen wird, wenn sich das System mit Hilfe einer geeigneten Frequenz bereits in seinem idealen Arbeitspunkt befindet und keine Annäherung einer Hand vorliegt. Die Differenz des ursprünglichen Wertes zu dem neuen Wert kann als Bezugsgröße für die Berechnung bzw. für das Bestimmen aller gewünschten Detektionsschwellen herangezogen werden, da diese Differenz in ihrer absoluten Größe alle Feldeigenschaften in sich trägt. Die Verkleinerung des Feldstromes kann mit Hilfe einer Verkleinerung der Spannung an der Sendeelektrode SE bewerkstelligt werden. Alternativ kann auch das Tastverhältnis in dem Rechtecksignal aus seiner Symmetrie gebracht werden, was mit dem Mikrocontroller µC geschehen kann.

Besonders vorteilhaft bei der in Fig. 20 bis Fig. 22 gezeigten Ausführungsform ist, dass die Flächen der Sendeelektrode und der Empfangselektrode gleichmäßig auf die zur Verfügung stehende Oberfläche des Handgerätes aufgeteilt werden kann, was eine effektive Steigerung der Messempfindlichkeit mit sich bringt.

Beispiele für eine Anordnung der Sendeelektrode SE und der Empfangselektrode EE an der Oberfläche eines Handgerätes sind mit Bezug auf die Fig. 23a bis 23c gezeigt.

**Fig. 23a** zeigt ein erstes Beispiel von zwei an einer Gehäuseoberfläche eines elektrischen Handgerätes angeordneten Elektroden. Die Sendeelektrode und die Empfangselektrode sind hier jeweils rechteckig ausgestaltet. Der Abstand zwischen der Sendeelektrode SE und der Empfangselektrode EE wird vorzugsweise sehr gering gewählt. Die Sendeelektrode SE und die Empfangselektrode EE sind jeweils mit einer Sensorelektronik S bzw. einer Auswerteeinrichtung A gekoppelt.

**Fig. 23b** zeigt ein zweites Beispiel von an einer Gehäuseoberfläche eines elektrischen Handgerätes angeordneten Elektroden. Die Elektroden weisen hier eine ovale Form auf, was die Empfindlichkeit der Annäherungsdetektion verbessert.

**Fig. 23c** zeigt ein weiteres Beispiel einer Elektrodenanordnung an einer Gehäuseoberfläche eines elektrischen Handgerätes. Die Sendeelektrode SE und die Empfangselektrode EE sind hier jeweils halbkreisförmig ausgestaltet. Der Abstand zwischen der Sendeelektrode SE und der Empfangselektrode EE wird vorzugsweise klein gewählt. Zwischen der Sendeelektrode SE und der Empfangselektrode EE ist die Sensorelektronik S bzw. die Auswerteeinrichtung A eingebettet. Damit kann in vorteilhafter Weise die gesamte Sensoreinrichtung, welche die Sendeelektrode SE, die Empfangselektrode EE und die Sensorelektronik S bzw. die Auswerteeinrichtung A umfasst, an der Gehäuseoberfläche eines elektrischen Handgerätes angeordnet werden. Die Signalübertragung der Sensorelektronik S bzw. der Auswerteeinrichtung A an die Elektronik des elektrischen Handgerätes kann hierbei galvanisch oder kapazitiv erfolgen. Die kapazitive Signalübertragung hat den Vorteil, dass an der Gehäuseoberfläche keine mechanischen Koppelstellen vorgesehen werden müssen.

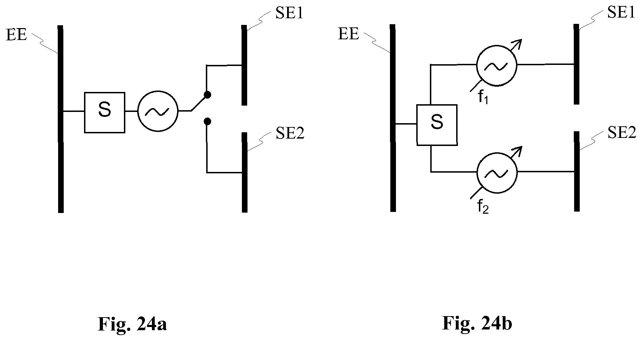

Die Fig. 24a und 24b zeigen zwei Beispiele einer Einrichtung mit jeweils einer Empfangselektrode und zwei Sendeelektroden, wobei die Sendeelektroden mit einem Multiplex-Verfahren betrieben werden.

**Fig. 24a** zeigt eine Sensoreinrichtung mit einer Empfangselektrode und zwei Sendeelektroden SE1 und SE2. Die Sendeelektroden SE1 und SE2 werden im Zeitmultiplexverfahren betrieben, d.h. die Sendeelektroden SE1 und SE2 werden zeitlich hintereinander mit einem Wechselsignal beaufschlagt, welches von einem Signalgenerator bereit gestellt wird. Die Sensorelektronik S, welche mit der Empfangselektrode EE gekoppelt ist, kann den in der Empfangselektrode EE fließenden Strom eindeutig einer Sendeelektrode zuordnen, da jeweils nur eine Sendeelektrode ein elektrisches Wechselfeld emittiert.

**Fig. 24b** zeigt eine Einrichtung mit einer Empfangselektrode EE und zwei Sendeelektroden SE1 und SE2. Die Sendeelektroden SE1 und SE2 werden hier im Frequenzmultiplexverfahren betrieben, d.h. die Frequenz des Wechselsignals, mit welchem die Sendeelektrode SE1 beaufschlagt wird, ist verschieden von der Frequenz des Wechselsignals, mit welchem die Sendeelektrode SE2 beaufschlagt wird. Die Frequenz f1 des ersten Wechselsignals kann beispielsweise 10 kHz betragen, die Frequenz f2 des zweiten Wechselsignals kann beispielsweise 50 kHz betragen. Die Sensorelektronik S, welche mit der Empfangselektrode EE gekoppelt ist, ist so ausgestaltet, dass sie den in der Empfangselektrode EE fliesenden Strom in seine Frequenzbestandteile zerlegen kann, um so die jeweiligen Ströme den entsprechenden Sendeelektroden zuordnen zu können. In einer einfachen Ausführungsform kann dies beispielsweise mit einer Fast-Fourier-Transformation bewerkstelligt werden.

Die mit Bezug auf Fig. 24a und 24b gezeigten Modulationsverfahren können auch mit mehr als zwei Sendeelektroden realisiert werden. Möglich ist auch, eine Sendeelektrode und mehrere Empfangselektroden EE vorzusehen, wobei die in den jeweiligen Empfangselektroden EE fliesenden Ströme mit Hilfe eines geeigneten Multiplexverfahrens, zum Beispiel einem Zeitmultiplexverfahren, gemessen bzw. ausgewertet werden.

Ebenfalls möglich ist es, mehrere Elektrodenelemente, welche jeweils aus mindestens einer Empfangselektrode und mindestens einer Sensorelektrode bestehen, in einem Multiplexverfahren zu betreiben.

### Bezugszeichenliste

- 10: Gehäuse eines elektrischen Handgerätes
- 20: Elektrisches Wechselfeld
- 30: Ablagefläche aus elektrisch leitendem Material
- 35: Ablagefläche aus elektrisch nicht leitendem Material
- 40: Isolation
- 50a: Elektrodenstapel für Sendeelektrode
- 50b: Elektrodenstapel für Empfangselektrode
- 60: Detektionsschwelle
- 70: elektrisch leitfähige Fläche
- A: Auswerteeinrichtung
- B: Batterie / Akkumulator
- F: Filter
- G: Signalgenerator
- H: Hand
- K: Komparator
- S: kapazitiver Sensor
- µC: Mikrocontroller
- Δϕ: Phasenschieber
- A/D: Analog-Digital-Wandler
- DS: Detektorsignal
- EE: Empfangselektrode
- SE: Sendeelektrode
- SE1, SE2: Sensorelektrode
- S1, S2: kapazitiver Sensor
- GE: mit dem Massepotential des elektrischen Handgerätes gekoppelte elektrisch leitfähige Struktur
- PCB: elektronische Leiterplatte (Printed Circuit Board)

## Patentansprüche

1. Elektrisches Handgerät, aufweisend zumindest eine Einrichtung zur Detektion eines Umgreifens des Handgerätes durch eine Hand (H), wobei das Handgerät ein Gehäuse (10) mit einer Unterseite und gegenüberliegenden Seitenwänden hat, aufweisend
- mindestens eine an einer der Seitenwände angeordnete Sendeelektrode (SE), von welcher ein elektrisches Wechselfeld emittierbar ist, und
- mindestens eine an der jeweiligen anderen Seitenwand angeordnete Empfangselektrode (EE), in welche das elektrische Wechselfeld zumindest teilweise einkoppelbar ist,
wobei die mindestens eine Sendeelektrode (SE) und die mindestens eine Empfangselektrode (EE) an dem Handgerät so angeordnet sind, dass sie beim Umgreifen des Handgerätes mit der Hand (H) jeweils zumindest teilweise von der Hand (H) überdeckt werden, sodass beim Umgreifen des Handgerätes mit der Hand (H) ein erster Anteil des von der Sendeelektrode (SE) emittierten elektrischen Wechselfeldes (20) über die Hand (H) in die Empfangselektrode (EE) eingekoppelt wird, wobei der erste Anteil des elektrischen Wechselfeldes (20) ein für ein Umfassen des Handgerätes durch die Hand (H) repräsentatives Merkmal ist, und
weiter aufweisend mindestens eine mit dem Massepotential des elektrischen Handgerätes gekoppelte elektrisch leitfähige Struktur (GE), wobei die elektrisch leitfähige Struktur (GE) so relativ zur Sendeelektrode (SE) und zur Empfangselektrode (EE) angeordnet ist, um bei Nicht-Umgreifen des Handgerätes ein Einkoppeln des von der Sendeelektrode (SE) emittierten elektrischen Wechselfeldes (20) in die Empfangselektrode (EE) im Wesentlichen zu verhindern.

2. Elektrisches Handgerät nach Anspruch 1, welches so ausgestaltet ist, dass
- ein zweiter Anteil des elektrischen Wechselfeldes (20) in die elektrisch leitfähige Struktur(GE) eingekoppelt wird, und
- ein dritter Anteil des elektrischen Wechselfeldes (20), welcher betragsmäßig kleiner ist als der zweite Anteil, in die Empfangselektrode (EE) eingekoppelt wird, wobei ohne Umgreifen des Handgerätes der dritte Anteil des elektrischen Wechselfeldes (20) betragsmäßig kleiner ist als der erste Anteil des elektrischen Wechselfeldes (20).

3. Elektrisches Handgerät nach einem der vorhergehenden Ansprüche, welches so ausgestaltet ist, dass ein an der Empfangselektrode erzeugter Strom (IG) oberhalb eines vorbestimmten Schwellenwertes (60) indikativ für ein Umfassen des Handgerätes ist.

4. Elektrisches Handgerät nach einem der vorhergehenden Ansprüche, wobei
- die Empfangselektrode (EE) mit einem kapazitiven Sensor (S) gekoppelt ist, welcher einen Signalgenerator (G) umfasst,
- das Ausgangssignal des kapazitiven Sensors (S) von der kapazitiven Belastung des Sensors (S) an der Empfangselektrode (EE) abhängig ist, und
- die Sendeelektrode (SE) über einen Phasenschieber (Δϕ) mit dem Signalgenerator (G) gekoppelt ist, um die Sendeelektrode (SE) mit einem Signal zu beaufschlagen, welches zum Signal des Signalgenerators (G) phasenverschobenen ist.

5. Elektrisches Handgerät nach einem der vorhergehenden Ansprüche, wobei die elektrisch leitfähige Struktur (GE) eine elektrisch leitfähige Schicht (GE) ist, die zwischen der Empfangselektrode (EE) und dem Gehäuse und/oder zwischen der Sendelektrode (SE) und dem Gehäuse (10) angeordnet ist, wobei die Fläche der elektrisch leitfähigen Schicht jeweils größer ist als die Fläche der Empfangselektrode (EE) und/oder der Sendelektrode (SE).

6. Elektrisches Handgerät nach einem der vorhergehenden Ansprüche, aufweisend zumindest zwei Sendelektroden (SEI, SE2), wobei die erste Sendelektroden (SEI) mit einem ersten elektrischen Wechselsignal beaufschlagbar ist und die zweite Sendelektrode (SE2) mit einem zweiten elektrischen Wechselsignal beaufschlagbar ist, wobei die Frequenz des ersten elektrischen Wechselsignals verschieden von der Frequenz des zweiten elektrischen Wechselsignal ist.

7. Elektrisches Handgerät nach Anspruch 6, wobei Auswerteeinrichtung ausgestaltet ist, die Frequenzanteile des in die Empfangselektrode eingekoppelten elektrischen Wechselfeldes zu trennen und der jeweiligen Sendelektrode zuzuordnen.

8. Elektrisches Handgerät nach einem der Ansprüche 1 bis 7, wobei die mindestens eine Sendeelektrode (SE) und die mindestens eine Empfangselektrode (EE) an dem Handgerät so angeordnet sind, dass sie beim Umgreifen des Handgerätes mit der Hand (H) jeweils zumindest teilweise von der Hand (H) überdeckt werden.

9. Elektrisches Handgerät nach einem der Ansprüche 1 bis 8, wobei das elektrische Handgerät ein Mobiltelefon, Eingabemittel für Spielkonsole, mobiler Kleincomputer, Kopfhörer, Hörgerät, Computermaus, oder Fernbedienung ist.

10. Verfahren zur Detektion eines Umgreifens eines elektrischen Handgerätes durch eine Hand mit einer Detektionseinrichtung, wobei das elektrische Handgerät ein Gehäuse mit einer Unterseite und gegenüberliegenden Seitenwänden aufweist, welche zumindest eine an einer der Seitenwände angeordnete Sendeelektrode (SE) und zumindest eine and der jeweiligen anderen Seitenwand angeordnete Empfangselektrode (EE) aufweist, wobei die zumindest eine Sendeelektrode (SE) mit einer elektrischen Wechselspannung beaufschlagt wird, sodass an der zumindest einen Sendeelektrode (SE) ein elektrisches Wechselfeld (20) emittiert wird, wobei
- beim Umgreifen des Handgerätes mit einer Hand ein erster Anteil des elektrischen Wechselfeldes (20) über die Hand (H) in die Empfangselektrode (EE) eingekoppelt wird, und
- der erste Anteil des elektrischen Wechselfeldes (20) in der Empfangselektrode (EE) einen ersten elektrischen Strom (Ii) erzeugt, welcher indikativ für ein Umfassen des Handgerätes ist wobei die Detektionseinrichtung zumindest eine mit dem Massepotential des elektrischen Handgerätes gekoppelte elektrisch leitfähige Struktur (GE) aufweist und wobei die elektrisch leitfähige Struktur (GE) so relativ zur Sendeelektrode (SE) und zur Empfangselektrode (EE) angeordnet wird, dass bei Nicht-Umgreifen des Handgerätes ein Einkoppeln des an der Sendeelektrode (SE) emittierten elektrischen Wechselfeldes (20) in die Empfangselektrode (EE) im Wesentlichen verhindert wird.

11. Verfahren nach Anspruch 10, wobei
- bei Nicht-Umgreifen des Handgerätes ein zweiter Anteil des elektrischen Wechselfeldes (20) in die elektrisch leitfähige Struktur (GE) eingekoppelt wird und ein dritter Anteil des elektrischen Wechselfeldes (20), welcher betragsmäßig kleiner ist als der zweite Anteil, in die Empfangselektrode (EE) eingekoppelt wird,
- bei Nicht-Umgreifen des Handgerätes der dritte Anteil des elektrischen Wechselfeldes (20) betragsmäßig kleiner ist als der erste Anteil des elektrischen Wechselfeldes (20).

12. Verfahren nach Ansprüche 10 oder 11, wobei
- ein Einschaltmodus und/oder ein Aktivmodus des Handgerätes herbeigeführt wird, wenn der Strom einen vorbestimmten Schwellenwert überschreitet; und/oder
- ein Schlafmodus des Handgerätes herbeigeführt wird, wenn der Strom einen vorbestimmten Schwellenwert unterschreitet.

## Claims

1. Electric handheld device, comprising at least one device for detecting the handheld device being clasped by a hand (H), wherein the handheld device has a housing (10) having an underside and opposite side walls, comprising
- at least one transmitting electrode (SE) arranged on one of the side walls and able to emit an alternating electric field, and
- at least one receiving electrode (EE) arranged on the respective other side wall, the alternating electric field being able to be coupled at least partly into said at least one receiving electrode,
wherein the at least one transmitting electrode (SE) and the at least one receiving electrode (EE) are arranged on the handheld device such that, in the event of the handheld device being clasped by the hand (H), they are covered in each case at least partly by the hand (H), such that in the event of the handheld device being clasped by the hand (H), a first portion of the alternating electric field (20) emitted by the transmitting electrode (SE) is coupled into the receiving electrode (EE) via the hand (H), wherein the first portion of the alternating electric field (20) is a feature representative of the handheld device being clasped by the hand (H), and further comprising at least one electrically conductive structure (GE) coupled to the earth potential of the electric handheld device, wherein the electrically conductive structure (GE) is arranged relative to the transmitting electrode (SE) and to the receiving electrode (EE) so as substantially to prevent the alternating electric field (20) emitted by the transmitting electrode (SE) from being coupled into the receiving electrode (EE) in the event of the handheld device not being clasped.

2. Electric handheld device according to Claim 1, which is configured such that
- a second portion of the alternating electric field (20) is coupled into the electrically conductive structure (GE), and
- a third portion of the alternating electric field (20), the absolute value of which is less than that of the second portion, is coupled into the receiving electrode (EE), wherein, without the handheld device being clasped, the absolute value of the third portion of the alternating electric field (20) is less than that of the first portion of the alternating electric field (20).

3. Electric handheld device according to either of the preceding claims, which is configured such that a current (IG) generated at the receiving electrode above a predetermined threshold value (60) is indicative of the handheld device being clasped.

4. Electric handheld device according to any of the preceding claims, wherein
- the receiving electrode (EE) is coupled to a capacitive sensor (S) comprising a signal generator (G),
- the output signal of the capacitive sensor (S) is dependent on the capacitive loading of the sensor (S) at the receiving electrode (EE), and
- the transmitting electrode (SE) is coupled to the signal generator (G) via a phase shifter (Δϕ) in order to apply to the transmitting electrode (SE) a signal which is phase-shifted with respect to the signal of the signal generator (G).

5. Electric handheld device according to any of the preceding claims, wherein the electrically conductive structure (GE) is an electrically conductive layer (GE) arranged between the receiving electrode (EE) and the housing and/or between the transmitting electrode (SE) and the housing (10), wherein the area of the electrically conductive layer is in each case larger than the area of the receiving electrode (EE) and/or of the transmitting electrode (SE).

6. Electric handheld device according to any of the preceding claims, comprising at least two transmitting electrodes (SEI, SE2), wherein a first alternating electric signal is able to be applied to the first transmitting electrode (SEI) and a second alternating electric signal is able to be applied to the second transmitting electrode (SE2), wherein the frequency of the first alternating electric signal is different from the frequency of the second alternating electric signal.

7. Electric handheld device according to Claim 6, wherein an evaluation device is configured to separate the frequency components of the alternating electric field coupled into the receiving electrode and to assign them to the respective transmitting electrode.

8. Electric handheld device according to any of Claims 1 to 7, wherein the at least one transmitting electrode (SE) and the at least one receiving electrode (EE) are arranged on the handheld device such that, in the event of the handheld device being clasped by the hand (H), they are covered in each case at least partly by the hand (H).

9. Electric handheld device according to any of Claims 1 to 8, wherein the electric handheld device is a mobile telephone, input means for a games console, a mobile minicomputer, headphones, a hearing aid, a computer mouse, or a remote control.

10. Method for detecting an electric handheld device being clasped by a hand by means of a detection device, wherein the electric handheld device comprises a housing having an underside and opposite side walls, comprising at least one transmitting electrode (SE) arranged on one of the side walls and at least one receiving electrode (EE) arranged on the respective other side wall, wherein an alternating electric voltage is applied to the at least one transmitting electrode (SE), such that an alternating electric field (20) is emitted at the at least one transmitting electrode (SE), wherein
- in the event of the handheld device being clasped by a hand, a first portion of the alternating electric field (20) is coupled into the receiving electrode (EE) via the hand (H), and
- the first portion of the alternating electric field (20) in the receiving electrode (EE) generates a first electric current (Ii) indicative of the handheld device being clasped, wherein the detection device comprises at least one electrically conductive structure (GE) coupled to the earth potential of the electric handheld device, and wherein the electrically conductive structure (GE) is arranged relative to the transmitting electrode (SE) and to the receiving electrode (EE) such that, in the event of the handheld device not being clasped, the alternating electric field (20) emitted at the transmitting electrode (SE) is substantially prevented from being coupled into the receiving electrode (EE).

11. Method according to Claim 10, wherein
- in the event of the handheld device not being clasped, a second portion of the alternating electric field (20) is coupled into the electrically conductive structure (GE), and a third portion of the alternating electric field (20), the absolute value of which is less than that of the second portion, is coupled into the receiving electrode (EE),
- in the event of the handheld device not being clasped, the absolute value of the third portion of the alternating electric field (20) is less than that of the first portion of the alternating electric field (20).

12. Method according to Claim 10 or Claim 11, wherein
- a switch-on mode and/or an active mode of the handheld device are/is brought about if the current exceeds a predetermined threshold value; and/or
- a sleep mode of the handheld device is brought about if the current falls below a predetermined threshold value.

## Revendications

1. Appareil portatif électrique, possédant au moins un dispositif de détection d'une saisie enveloppante de l'appareil portatif par une main (H), l'appareil portatif ayant un boîtier (10) pourvu d'un côté inférieur et de parois latérales opposées, comprenant
- au moins une électrode d'émission (SE) disposée sur l'une des parois latérales, depuis laquelle peut être émis un champ électrique alternatif, et
- au moins une électrode de réception (EE) disposée sur l'autre paroi latérale respective, dans laquelle le champ électrique alternatif peut être injecté au moins partiellement,
l'au moins une électrode d'émission (SE) et l'au moins une électrode de réception (EE) étant respectivement disposées au niveau de l'appareil portatif de telle sorte que lors de la saisie enveloppante de l'appareil portatif avec la main (H), elles sont respectivement au moins partiellement recouvertes par la main (H),
de sorte que lors de la saisie enveloppante de l'appareil portatif avec la main (H), une première part du champ électrique alternatif (20) émis par l'électrode d'émission (SE) est injectée dans l'électrode de réception (EE) par le biais de la main (H),
la première part du champ électrique alternatif (20) étant une caractéristique représentative pour une saisie enveloppante de l'appareil portatif par la main (H), et comprenant en outre au moins une structure électriquement conductrice (GE) connectée au potentiel de masse de l'appareil portatif électrique, la structure électriquement conductrice (GE) étant disposée par rapport à l'électrode d'émission (SE) et à l'électrode de réception (EE) de manière à empêcher sensiblement une injection du champ électrique alternatif (20) émis par l'électrode d'émission (SE) dans l'électrode de réception (EE) en l'absence de saisie enveloppante de l'appareil portatif.

2. Appareil portatif électrique selon la revendication 1, lequel est configuré de telle sorte que
- une deuxième part du champ électrique alternatif (20) est injectée dans la structure électriquement conductrice (GE) et
- une troisième part du champ électrique alternatif (20), dont la valeur absolue est inférieure à celle de la deuxième part, est injectée dans l'électrode de réception (EE),
en l'absence de saisie enveloppante de l'appareil portatif, la valeur absolue de la troisième part du champ électrique alternatif (20) étant inférieure à celle de la première part du champ électrique alternatif (20).

3. Appareil portatif électrique selon l'une des revendications précédentes, lequel est configuré de telle sorte qu'un courant (IG) généré au niveau de l'électrode de réception supérieur à une valeur de seuil (60) prédéterminée est indicatif d'une saisie enveloppante de l'appareil portatif.

4. Appareil portatif électrique selon l'une des revendications précédentes,
- l'électrode de réception (EE) étant connectée à un capteur capacitif (S) qui comporte un générateur de signaux (G),
- le signal de sortie du capteur capacitif (S) étant dépendant de la sollicitation capacitive du capteur (S) au niveau de l'électrode de réception (EE), et
- l'électrode d'émission (SE) étant connectée au générateur de signaux (G) par le biais d'un déphaseur (Δϕ) afin d'alimenter l'électrode d'émission (SE) avec un signal qui est déphasé par rapport au signal du générateur de signaux (G).

5. Appareil portatif électrique selon l'une des revendications précédentes, la structure électriquement conductrice (GE) étant une couche électriquement conductrice (GE) qui est disposée entre l'électrode de réception (EE) et le boîtier et/ou entre l'électrode d'émission (SE) et le boîtier (10), la surface de la couche électriquement conductrice étant respectivement plus grande que la surface de l'électrode de réception (EE) et/ou de l'électrode d'émission (SE).

6. Appareil portatif électrique selon l'une des revendications précédentes, possédant au moins deux électrodes d'émission (SE1, SE2), la première électrode d'émission (SE1) pouvant être alimentée avec un premier signal alternatif électrique et la deuxième électrode d'émission (SE2) pouvant être alimentée avec un deuxième signal alternatif électrique, la fréquence du premier signal alternatif électrique étant différente de la fréquence du deuxième signal alternatif électrique.

7. Appareil portatif électrique selon la revendication 6, un dispositif d'interprétation étant configuré pour séparer les parts de fréquence du champ électrique alternatif injecté dans l'électrode de réception et les attribuer à l'électrode d'émission respective.

8. Appareil portatif électrique selon l'une des revendications 1 à 7, l'au moins une électrode d'émission (SE) et l'au moins une électrode de réception (EE) étant respectivement disposées au niveau de l'appareil portatif de telle sorte que lors de la saisie enveloppante de l'appareil portatif avec la main (H), elles sont respectivement au moins partiellement recouvertes par la main (H).

9. Appareil portatif électrique selon l'une des revendications 1 à 8, l'appareil portatif électrique étant un téléphone mobile, un moyen de saisie pour une console de jeu, un microordinateur mobile, un casque d'écoute, un appareil auditif, une souris informatique ou une télécommande.

10. Procédé de détection d'une saisie enveloppante d'un appareil portatif électrique par une main avec un dispositif de détection, l'appareil portatif électrique comprenant un boîtier pourvu d'un côté inférieur et de parois latérales opposées, lequel comprend au moins une électrode d'émission (SE) disposée sur l'une des parois latérales et au moins une électrode de réception (EE) disposée sur l'autre paroi latérale respective, l'au moins une électrode d'émission (SE) étant alimentée avec une tension alternative électrique, de sorte qu'un champ électrique alternatif (20) soit émis au niveau de l'au moins une électrode d'émission (SE),
- lors de la saisie enveloppante de l'appareil portatif avec une main, une première part du champ électrique alternatif (20) est injectée dans l'électrode de réception (EE) par le biais de la main (H), et
- la première part du champ électrique alternatif (20) générant dans l'électrode de réception (EE) un premier courant électrique (Ii) qui est indicatif d'une saisie enveloppante de l'appareil portatif, le dispositif de détection possédant au moins une structure électriquement conductrice (GE) connectée au potentiel de masse de l'appareil portatif électrique et la structure électriquement conductrice (GE) étant disposée par rapport à l'électrode d'émission (SE) et à l'électrode de réception (EE) de manière à empêcher sensiblement une injection du champ électrique alternatif (20) émis au niveau de l'électrode d'émission (SE) dans l'électrode de réception (EE) en l'absence de saisie enveloppante de l'appareil portatif.

11. Procédé selon la revendication 10,
- en l'absence de saisie enveloppante de l'appareil portatif, une deuxième part du champ électrique alternatif (20) est injectée dans la structure électriquement conductrice (GE) et une troisième part du champ électrique alternatif (20), dont la valeur absolue est inférieure à celle de la deuxième part, est injectée dans l'électrode de réception (EE),
- en l'absence de saisie enveloppante de l'appareil portatif, la valeur absolue de la troisième part du champ électrique alternatif (20) étant inférieure à celle de la première part du champ électrique alternatif (20).

12. Procédé selon les revendications 10 ou 11
- un mode de mise en marche et/ou un mode actif de l'appareil portatif étant provoqué lorsque le courant dépasse une valeur de seuil prédéterminée ; et/ou
- un mode de veille de l'appareil portatif étant provoqué lorsque le courant devient inférieur à une valeur de seuil prédéterminée.
